# EUROPÄISCHE PATENTSCHRIFT

(11) **EP 2 168 177 B1**
(45) Veröffentlichungstag und Bekanntmachung des Hinweises auf die Patenterteilung: **04.09.2019**
(21) Anmeldenummer: 08785978.1
(22) Anmeldetag: 08.07.2008
(51) Int. Cl.: H01L 31/048, H01L 31/0392, H01L 31/18

(54) **Herstellungsverfahren eines Dünnschichtsolarzellen-Moduls**
Fabrication method of a thin-film solar cell module
Méthode de fabrication d'un module de piles solaires en couches minces

(30) Priorität: 11.07.2007 DE 102007032283
(43) Veröffentlichungstag der Anmeldung: 31.03.2010
(73) Patentinhaber: Stein, Wilhelm, 01324 Dresden (DE)
(72) Erfinder:
(74) Vertreter: Epping - Hermann - Fischer
(86) Internationale Anmeldenummer: PCT/EP2008/058864
(87) Internationale Veröffentlichungsnummer: WO 2009/007375

(56) Entgegenhaltungen:
- EP-A- 0 320 089
- GB-A- 1 575 888
- US-A- 4 879 251
- US-A- 5 453 134
- US-A1- 2006 278 497

## Beschreibung

Die Erfindung betrifft ein Verfahren zur Herstellung eines Dünnschichtsolarzellen-Moduls mit einer Vielzahl von auf einem gemeinsamen Substrat angeordneten und elektrisch in Reihe geschalteten Segmenten.

Dünnschichtsolarzellen-Module, auch Dünnschichtphotovoltaik-Module genannt, weisen photoaktive Schichten mit Schichtdicken in der Größenordnung von Mikrometern auf. Das in der oder den photoaktiven Schichten eingesetzte Halbleitermaterial kann dabei amorph oder mikrokristallin sein. Auch eine Kombination von Schichten aus amorphen und Schichten aus mikrokristallinem Halbleitermaterial innerhalb einer Zelle ist möglich, zum Beispiel bei den so genannten Tandemzellen und den so genannten Tripelzellen. Als Halbleitermaterialien kommen Si, Ge und Verbindungshalbleiter wie CdTe oder Cu(In, Ga)Se2 (kurz CIS oder CIGS genannt) zum Einsatz. Trotz eines etwas geringeren Wirkungsgrades stellen Dünnschichtsolarzellen-Module wegen ihres deutlich geringeren Materialbedarfs eine wirtschaftlich und technisch relevante Alternative zu Solarzellenmodulen dar, die auf der Basis einkristalliner oder polykristalliner Halbleiterschichten makroskopischer Dicke hergestellt sind.

Um wirtschaftliche Module mit möglichst großer Fläche einsetzen zu können, ohne dass der in den Elektroden der Solarzellen lateral abgeführte Strom so groß wird, dass hohe ohmsche Verluste auftreten, werden Dünnschichtsolarzellen-Module üblicherweise in eine Vielzahl von Segmenten unterteilt. Die streifenförmigen und in der Regel einige Millimeter bis Zentimeter breiten Segmente verlaufen dabei meist parallel zu einer Kante des Moduls. Die Segmente werden gebildet, indem bei durchgehendem Substrat einzelne Schichten des Schichtaufbaus der Solarzelle durch dünne Trennlinien unterbrochen werden. Die Trennlinien führen zum einen dazu, dass gleiche Schichten benachbarter Segmente gegeneinander elektrisch isoliert sind und zum anderen dazu, dass nachfolgend aufgebrachte Schichten entlang einer Kontaktlinie mit darunter liegenden Schichten elektrisch verbunden werden können. Bei geeigneter Anordnung der Trennlinien lässt sich auf diese Weise eine Serienschaltung der einzelnen Segmente erreichen.

Nach dem Stand der Technik erfolgt das Ausbilden einer Trennlinie jeweils unmittelbar nach Aufbringen einer Schicht. Da das Aufbringen von Schichten üblicherweise unter Vakuumbedingungen erfolgt, das Ausbilden der Trennlinien jedoch räumlich getrennt davon unter Atmosphärenbedingungen, erfordert der Herstellungsprozess nach dem Stand der Technik eine komplizierte Prozessführung. Weiterhin besteht bei den häufigen Ein- und Ausschleusevorgängen in und aus dem Vakuum die Gefahr der Einlagerung von Verunreinigungen zwischen den Schichten einer Solarzelle. Auch während der Strukturierungsvorgänge abgetragenes Material, das sich auf den Schichten absetzt, kann eine solche Verunreinigung darstellen.

Die EP 0 320 089 A2 betrifft eine Solarzelle aus einer Halbleiterschicht und einer auf einem flexiblen Substrat ausgebildeten leitfähigen Schicht, unterteilt in einzelne Segmente, die durch Zwischenverbindungsschichten in Reihe miteinander verschaltet sind.

Die US 2006/278497 A1 betrifft ein Herstellungsanlage mit zwei Vakuumschleusen und einer Mehrzahl von Prozesskammern zwischen den Vakuumschleusen.

Es ist eine Aufgabe der Erfindung, ein Verfahren zur Herstellung eines Dünnschichtsolarzellen-Moduls aufzuzeigen, das eine einfachere und effektivere Prozessführung erlaubt.

Diese Aufgaben wird gelöst durch die Merkmale des unabhängigen Patentanspruchs. Vorteilhafte Ausgestaltungen und Weiterbildungen sind Gegenstand der abhängigen Patentansprüche.

Gemäß einem ersten Aspekt der Erfindung wird die Aufgabe gelöst durch ein Verfahren zur Herstellung eines Dünnschichtsolarzellen-Moduls mit einer Vielzahl von auf einem gemeinsamen Substrat angeordneten und elektrisch in Reihe geschalteten Segmenten, wobei das Verfahren Schritte zum Aufbringen von Schichten auf das Substrat zur Bildung mindestens einer Elektrode und einer photoaktiven Schichtfolge und einer weiteren Elektrode aufweist und Schritte zum Strukturieren aufgebrachter Schichten zur Bildung der Vielzahl von Segmenten aufweist. Die Schritte zum Strukturieren umfassen ein Erzeugen einer Trennlinie, die die Elektrode, die photoaktive Schichtenfolge und die weitere Elektrode unterbricht, und ein Aufbringen eines elektrisch leitfähigen Klebebands oder eines leitfähigen Strangs aus einer leitfähigen Paste über die Trennlinie, wodurch die Unterbrechung der weiteren Elektrode durch die Trennlinie elektrisch wieder geschlossen wird. Mindestens eine Elektrode und eine photoaktive Schichtfolge und eine weitere Elektrode werden aufgebracht, bevor Schritte zum Strukturieren ausgeführt werden.

Es wird folglich zunächst eine Gruppe von mindestens drei Prozessen zur Schichtabscheidung durchgeführt, bevor strukturierende Schritte zur Segmentierung ausgeführt werden. Die zusammenfassende Gruppierung von Prozessschritten, die jeweils unter vergleichbaren Bedingungen (beispielsweise Vakuum- gegenüber Atmosphärenbedingungen) ausgeführt werden, erleichtert die Prozessführung und ist geeignet, ein Einbringen von Verunreinigungen zwischen den Schichten bei Dünnschichtsolarzellen-Modulen zu vermindern.

In einer vorteilhaften Ausgestaltung des Verfahrens erfolgt eine Strukturierung bereits aufgebrachter Schichten durch das Erstellen einer Trennlinie durch Einstrahlen von Laserstrahlung und/oder durch mechanisches Ritzen und/oder durch selektives Ätzen. Besonders bevorzugt wird dabei Laserstrahlung derart eingestrahlt, dass eine oder mehrere Schichten lokal entfernt werden oder dass eine oder mehrere Schichten lokal derart aufgeheizt werden, dass sich die physikalischen Eigenschaften mindestens einer der Schichten, insbesondere ihre Leitfähigkeit, verändert.

In einer weiteren vorteilhaften Ausgestaltung des Verfahrens erfolgt eine Strukturierung bereits aufgebrachter Schichten durch das Erstellen einer Kontaktlinie durch Einstrahlen von Laserstrahlung. Besonders bevorzugt wird dabei Laserlicht derart eingestrahlt, dass übereinander liegende Schichten aus unterschiedlichen Materialien lokal aufgeheizt werden und sich eine Materialverbindung ausbildet, die von den ursprünglichen Materialien abweichende physikalische Eigenschaften hat und insbesondere leitfähig ist.

In einer weiteren vorteilhaften Ausgestaltung des Verfahrens wird eine Isolierlinie aus einem elektrisch isolierenden Material innerhalb einer der Trennlinien erstellt. Besonders bevorzugt wird dabei die Isolierlinie durch ein Tintenstrahldruckverfahren aufgebracht.

Gemäß einer weiteren vorteilhaften Ausgestaltung des Verfahrens erfolgt eine Strukturierung nachfolgend aufzubringender Schichten mithilfe einer Abdecklinie aus einem löslichen Material. Besonders bevorzugt wird dabei die Abdecklinie durch ein Tintenstrahldruckverfahren aufgebracht.

Die genannten vorteilhaften Ausgestaltung des Verfahrens nach dem ersten Aspekt der Erfindung geben Strukturierungsmaßnahmen an, die geeignet sind, eine Strukturierung einer (einzelnen) Schicht auch innerhalb eines Schichtenstapels mit wenigstens zwei aufeinander aufgebrachten Schichten durchzuführen. Sie stellen daher ideale Strukturierungsmaßnahmen für das anmeldungsgemäße Verfahren dar.

Beispielsweise weist ein Dünnschichtsolarzellen-Modul mit einer Vielzahl von elektrisch in Reihe geschalteten Segmenten ein elektrisch leitfähiges Klebeband oder ein Strang einer leitfähigen Paste im Bereich einer Trennlinie auf, die eine erste Elektrode des Dünnschichtsolarzellen-Moduls zur Bildung der Segmente und eine zweite Elektrode unterbricht. Das elektrisch leitfähige Klebeband oder der Strang der leitfähigen Paste ist zur Wiederherstellung der elektrischen Verbindung auf die zweite Elektrode aufgebracht.

Bei den Dünnschichtsolarzellen-Modulen sind die verschiedenen Schichten (Elektroden und photoaktive Schichtfolge) beispielsweise derart Strukturiert, dass eine Serienverschaltung ausgeführt werden kann, nachdem bereits mindestens drei Schichten aufgebracht sind. Die Zusammenfassung der Prozessschritte zum Aufbringen der Schichten resultiert bei den Dünnschichtsolarzellen-Modulen in geringeren Verunreinigungen, z.B. durch häufige Ein- und Ausschleuseprozesse, und somit in einer besseren Schichtqualität, aus der sich eine höhere Effizienz der Zelle ergibt. Darüber hinaus können bei den vorgestellten Dünnschichtsolarzellen-Modulen die Prozessschritte zum Strukturieren von Schichten zusammengefasst werden, was eine bessere Positionierung der Strukturierungsmaßnahmen in verschiedenen Schichten zueinander führt. Dadurch ergibt sich ein kleiner Kontaktbereich für die Serienverschaltung und folglich ein höherer Flächenertrag der Zelle.

Im Folgenden werden Beispiele mit Hilfe von fünf Figuren näher erläutert.

Es zeigen:
Figur 1 eine schematische Darstellung eines Schichtaufbaus eines Dünnschichtsolarzellen-Moduls nach dem Stand der Technik,
Figuren 2 bis 4 schematische Darstellung des Schichtaufbaus von Dünnschichtsolarzellen-Modulen, jeweils zu verschiedenen Verfahrensstadien in einem der anmeldungsgemäßen Verfahren, wobei die Abbilgung 4 dem erfindungsgemäßen Verfahren entspricht.
Figur 5 eine Vorrichtung zur Herstellung von Dünnschichtsolarzellen-Modulen.

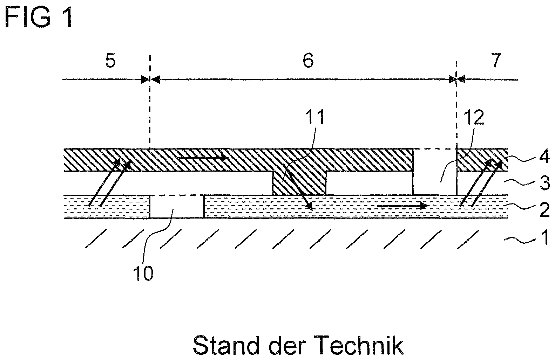

Figur 1 zeigt den Schichtaufbau eines Dünnschichtsolarzellen-Moduls nach dem Stand der Technik in einer schematischen Darstellung. Auf ein Substrat 1 ist eine erste Elektrode 2, eine photoaktive Schichtenfolge 3 und eine zweite Elektrode 4 aufgebracht. Die erste Elektrode 2, die photoaktive Schichtenfolge 3 und die zweite Elektrode 4 sind durch Trennlinien 10, 11, 12 lateral unterbrochen. Die drei Trennlinien 10, 11, 12 sind ihrerseits lateral zueinander beabstandet und teilen den dargestellten Ausschnitt des Dünnschichtsolarzellen-Moduls in ein erstes Segment 5 links der Trennlinie 10, ein zweites Segment 7 rechts der Trennlinie 12 sowie einen dazwischen liegenden Kontaktierungsbereich 6.

Üblicherweise werden die Elektroden 2, 4 und die photoaktive Schichtenfolge 3 bei Dünnschichtsolarzellen-Modulen in Vakuumprozessen aufgebracht. Hierfür eignen sich PVD-Prozesse (physical vapour deposition) wie zum Beispiel Plasma-Sputtern oder Elektronenstrahlverdampfen oder auch CVD-Prozesse (chemical vapor deposition) wie zum Beispiel LPCVD (low pressure CVD) oder PECVD (plasma enhanced CVD).

Als aktives Halbleitermaterial für die photoaktive Schichtenfolge 3 können amorphe oder mikrokristalline Halbleiter der Gruppe IV, zum Beispiel a-Si, a-SiGe, µC-Si, oder Verbindungshalbleiter wie zum Beispiel CdTe oder Cu(In, Ga)Se2 (kurz CIS oder CIGS genannt) eingesetzt werden. Dabei können in der photoaktiven Schichtenfolge 3 auch Schichten verschiedener der genannten Materialen kombiniert werden. Weiterhin können in der photoaktive Schichtenfolge 3 teilweise spiegelnde Schichten (intermediate reflectors) aus einem leitfähigen Oxid und/oder einer leitfähigen Halbleiterschicht vorgesehen sein.

Die photoaktive Schichtenfolge 3 umfasst typischerweise zumindest eine p- und eine n-dotierte Halbleiterschicht, das heißt einen Diodenübergang. Im Falle von Dünnschichtsolarzellen auf der Basis von Silizium werden die p- und die n-dotierten Schichten üblicherweise noch durch eine ausgedehnte intrinsische Schicht (i-Schicht) getrennt. Zur besseren Ausnutzung des Wellenlängenspektrums können mehrere pin-Schichtenstapel mit unterschiedlichen Absorptionsspektren übereinander vorgesehen sein. Die Si-Tandemzelle weist beispielsweise einen pin-Schichtenstapel aus a-Si und einen pin-Schichtenstapel aus µC-Si auf und bei der Si-Tripelzelle ist zusätzlich noch ein pin-Schichtenstapel aus a-Si(Ge) vorgesehen. Es wird in diesem Zusammenhang ausdrücklich darauf hingewiesen, dass im Rahmen der Anmeldung die photoaktive Schichtenfolge 3 nicht auf einen pin- oder nip-Schichtenstapel (Diodenübergang) beschränkt ist, sondern Mehrfachstapel wie den von Tandem- oder Tripelzellen umfasst. Typischerweise ist die p-dotierte Schicht der Sonne zugewandt. Bezüglich des Herstellungsprozesses wird in Anlehnung an die Reihenfolge, in der die unterschiedlich dotierten Schichten der photoaktiven Schichtenfolge 3 aufgebracht werden, zwischen so genannten pin-Zellen und nip-Zellen unterschieden. Bei pin-Zellen ist das (Aufwachs-) Substrat 1 transparent und bildet bei dem fertigen Modul auch das der Sonne zugewandte Trägersubstrat. Typischerweise wird dazu (Flach-) Glas eingesetzt. Bei nip-Zellen kann als Aufwachssubstrat Glas oder auch eine (Metall-) Folie eingesetzt werden. Das Trägersubstrat, durch das im Betrieb das Sonnenlicht einfällt, wird erst am Ende des Herstellungsprozesses auf das Modul auflaminiert. Der nip-Schichtenstapel bleibt dabei mit dem Aufwachssubstratverbunden.

Alle dargestellten Ausführungsbeispiele zeigen pin-Zellen. Dieses ist rein beispielhaft und stellt keine Einschränkung dar. Alle im Rahmen der Anmeldung beschriebenen Verfahren sind sowohl bei pin-Zellen als auch nip-Zellen anwendbar.

In dem in der Figur 1 gezeigten Beispiel einer pin-Zelle wird die der Sonne zugewandte erste Elektrode 2, die im Folgenden auch Frontseitenelektrode genannt wird, üblicherweise aus transparenten leitfähigen Oxiden (TCO, transparent conductive oxides), wie zum Beispiel SnO2 oder ZnO oder ITO (indium tinn oxide), gebildet. Die der Sonne abgewandte zweite Elektrode 4, im Folgenden auch Rückseitenelektrode genannt, kann ebenfalls eine TCO-Schicht aufweisen oder auch durch Metalle wie Ag, Al, Mo oder aus einer Kombination von TCO und einer Metallschicht gebildet werden.

Bei einer Übertragung der in der Anmeldung beschriebenen Verfahren auf nip-Zellen ist zu beachten, dass sich die Funktion der Elektroden 2 und 4 entsprechend umkehrt. Die zuerst aufgebrachte erste Elektrode 2 kann bei einer nip-Zelle eine Metallschicht umfassen und stellt die im Betrieb von der Sonne abgewandte Rückseitenelektrode dar. Entsprechend ist die zuletzt aufgebrachte zweite Elektrode 4 transparent ausgeführt und bildet die der Sonne zugewandte Frontseitenelektrode.

Im Herstellungsprozess des in Figur 1 gezeigten Dünnschichtsolarzellen-Moduls nach dem Stand der Technik wird zunächst die Frontseitenelektrode 2, beispielsweise TCO, auf das Substrat 1, beispielsweise Glas, aufgebracht. Anschließend wird die Trennlinie 10 in der Frontseitenelektrode 2 durch Laserstrahlung geeigneter Wellenlänge von z.B. 1064 nm oder auch durch mechanisches Ritzen oder auch durch selektives Ätzen erzeugt. Diese Trennlinie 10 verläuft über die gesamte Breite des Moduls (in der Figur senkrecht zur Blattebene). Die Laserstrahlung kann dabei sowohl durch das Substrat 1 als auch von der Schichtseite her eingestrahlt werden. Die Trennlinie 10 durchtrennt die Elektrode 2 in ihrer gesamten Höhe auf einer Breite von 5 bis 1000 um, wobei typische Breiten im Bereich von 10 bis 50 µm liegen. Nach erfolgter Strukturierung der Frontseitenelektrode 2 wird die photoaktive Schichtenfolge 3 aufgebracht und anschließend durch Erzeugung der Trennlinie 11 strukturiert. Die Trennlinie 11 in der photoaktive Schichtenfolge 3 wird bei Einsatz von Si als photoaktivem Material üblicherweise durch Einstrahlung von Laserlicht einer Wellenlänge von 532 nm erzeugt. Schließlich wird die Rückseitenelektrode 4 aufgebracht, die im Bereich der Trennlinie 11 in unmittelbaren Kontakt mit der Frontseitenelektrode 2 kommt. In einem letzten Schritt wird die Trennlinie 12 erzeugt, um die Rückseitenelektrode 4 des ersten Segments 5 von der Rückseitenelektrode 4 des zweiten Segments 7 elektrisch zu trennen. Üblich ist hier, durch das Substrat 1 Laserstrahlung einer Wellenlänge einzubringen, die nicht von der Frontseitenelektrode 2, sondern von der photoaktiven Schichtenfolge 3 absorbiert wird, also z.B. wiederum 532 nm, sodass die photoaktive Schichtenfolge 3 verdampft, wobei die metallische Rückseitenelektrode 4 aufschmelzen kann und im Bereich der Trennungslinie 12 abgesprengt wird oder auch ihrerseits verdampfen kann. Die sich abwechselnden Schritte zum Aufbringen der Schichten und zur Strukturierung der Schichten führen zu einer Serienverschaltung der beiden Segmente 5 und 7, wie durch die den Stromverlauf symbolisierenden Pfeile in der Figur 1 ersichtlich wird.

Prozesstechnisch ergibt sich die Schwierigkeit, dass sich im Vakuum ablaufende Schritte zur Schichtabscheidung mit unter Atmosphärenbedingungen (Umgebungsluft oder auch Schutzgasatmosphäre) ablaufenden und in einer gänzlich anderen Prozessstation stattfindenden Strukturierungsschritten zur Bildung der Trennlinien 10, 11, 12 abwechseln. Neben einem erhöhten Aufwand in der Prozessführung bergen die entsprechend häufig notwendigen Ein- und Ausschleusungsvorgänge die Gefahr, dass sich Verunreinigungen zwischen den Schichten ablagern.

Weiterhin ist es bei Dünnschichtsolarzellen erstrebenswert, den Kontaktbereich 6 möglichst schmal auszuführen, da er inaktive Fläche darstellt, die den Flächenertrag des Solarzellenmoduls vermindern. Die getrennten Strukturierungsprozesse, zwischen denen das Substrat zu dem in andere Prozesskammern zur Aufbringen der Schichten verfahren wird, führt jedoch zwangsläufig zu Ungenauigkeiten in der Positionierung der Trennlinien 10, 11, 12 zueinander. Als Folge ist es unerlässlich, den Abstand der Trennlinien 10, 11, 12 zueinander von vorneherein so breit zu wählen, dass die unvermeidbare Positionierungsungenauigkeit unschädlich für eine korrekte Ausführung der Serienverschaltung der Segmente ist.

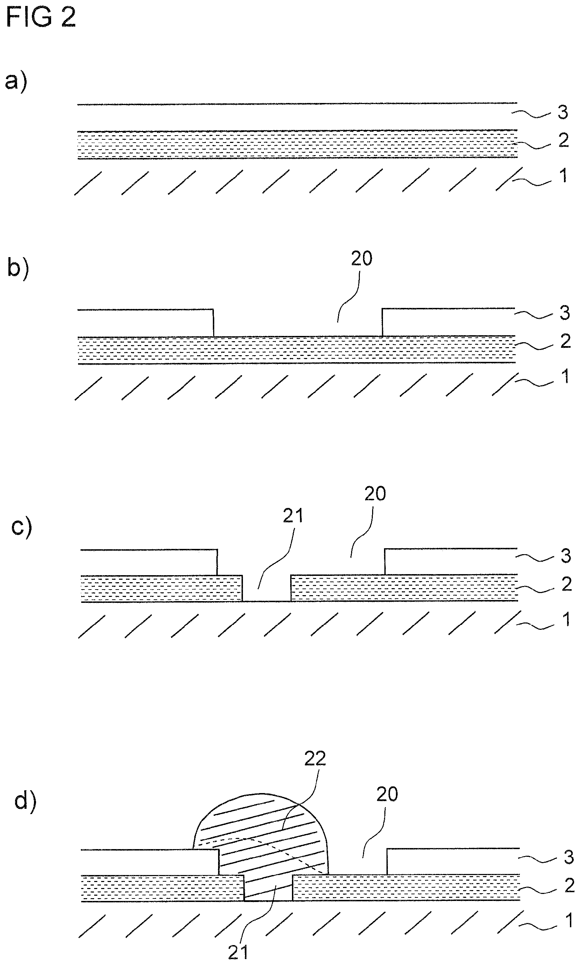

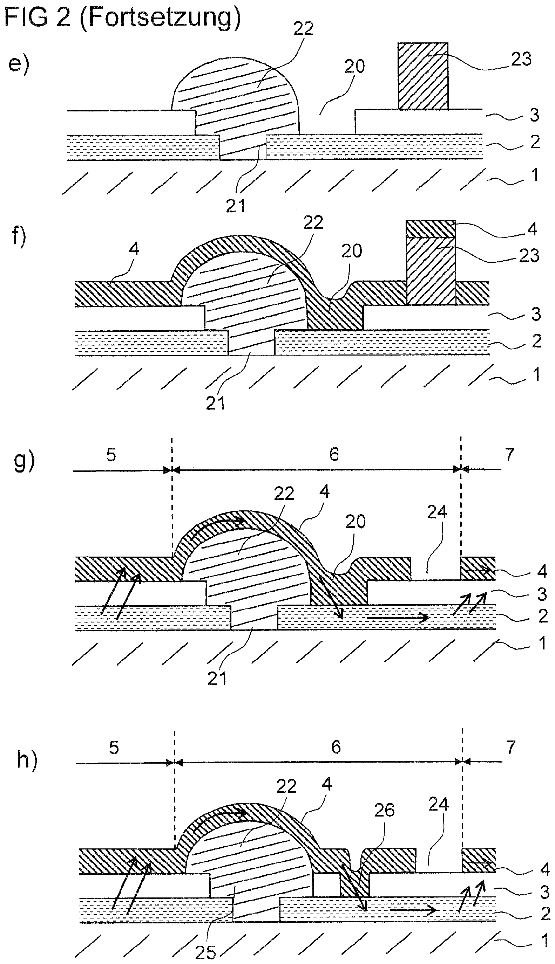

Figur 2 illustriert ein erstes Beispiel eines Verfahrens zur Herstellung eines Dünnschichtsolarzellen-Moduls.

Wie Figur 2a zeigt, werden zunächst auf ein Substrat 1 eine erste Elektrode 2 und eine photoaktive Schichtenfolge 3 aufgebracht. Beispielhaft handelt es sich bei dem Substrat 1 um Flachglas, bei der ersten Elektrode 2 um eine Frontseitenelektrode aus TCO und bei der photoaktiven Schichtenfolge 3 um eine Abfolge von p-dotiertem, intrinsischem und n-dotiertem amorphen oder mikrokristallinen Silizium. Die Frontseitenelektrode 2 und die photoaktive Schichtenfolge 3 können in aufeinander folgenden Vakuumbeschichtungsprozessen aufgebracht werden, ohne dass das Substrat 1 dazu aus dem Vakuum geschleust werden muss. Ebenso ist es möglich mit einem Substrat 1 zu starten, das bereits mit einer TCO-Schicht als Frontseitenelektrode 2 versehen ist. In dem Fall ist nur die photoaktive Schichtenfolge 3 aufzubringen.

Nach dem Ausschleusen des Substrats 1 aus dem Vakuum erfolgt ein erster Strukturierungsschritt, in dem die photoaktive Schichtenfolge 3 zur Bildung einer Trennlinie 20 auf einer Breite von > 100 µm und typisch 150 um unterbrochen wird. Dieses kann zum Beispiel durch Einbringen von Laserstrahlung einer Wellenlänge von 532 nm entweder von der Schichtseite her oder durch das Substrat 1 erfolgen. Der resultierende Schichtaufbau ist schematisch in Figur 2b gezeigt. Anschließend wird innerhalb des Bereichs der Trennungslinie 20 eine weitere Trennungslinie 21 erzeugt, die die Frontseitenelektrode 2 auf einer Breite von typisch 10 bis 40 um unterbricht (siehe Figur 2c). Zur Bildung der Trennungslinie 21 ist Laserstrahlung einer Wellenlänge von 1046 nm oder 355 nm geeignet. Vorteilhafterweise ist die Trennlinie 21 nicht zentriert zur Trennlinie 20 positioniert, sondern ist im linken Bereich der Trennlinie 20 angeordnet, beispielsweise so, dass die linken Kanten der Trennlinien 20 und 21 etwa 20 bis 30 µm lateral voneinander beabstandet sind. Wie die Trennlinie 20 kann auch die Trennlinie 21 mithilfe von Laserstrahlung erzeugt werden, die von der Schichtseite her oder von der Substratseite her eingestrahlt wird.

Dabei ist bevorzugt, dass die zur Bildung der Trennlinien 20 und 21 benötigte Laserstrahlung von einem einzigen Prozesskopf, der über das Substrat 1 verfährt, bereitgestellt wird, damit eine möglichst exakte, über die gesamte Länge der Trennlinien konstante Positionierung der beiden Trennlinien 20 und 21 zueinander gewährleistet ist.

Danach wird wie in Figur 2d dargestellt eine Isolierlinie 22 gleich einem elektrisch isolierenden Strang entlang der Trennlinie 21 aufgebracht. Vorteilhafterweise füllt die Isolierlinie 22 die Trennlinie 21 aus und ragt an beiden Seiten etwa 20 bis 30 um in die Trennlinie 20 hinein, so dass die linke Kante der Trennlinie 20 isoliert und passiviert wird. Wichtig ist jedoch, dass ein ausreichender, typischerweise 20 bis 50 um breiter Bereich der Frontseitenelektrode 2 in der Trennungslinie 20 nicht von der Isolierlinie 22 bedeckt ist. Die Höhe der Isolierlinie 22 kann typischerweise 5 bis 50 µm betragen.

Zum Aufbringen der Isolierlinie 22 ist insbesondere ein Tintenstrahldruckverfahren geeignet. Als Isolatormaterial kann ein elektrisch isolierendes und nach dem Auftragen aushärtendes Polymer eingesetzt werden.

Das Höhen- zu Breitenverhältnis der Isolierlinie 22 kann dabei sowohl durch die Aufbringungstechnik des Isolatormaterials als auch seine Fließeigenschaften bestimmt werden. Dabei sollte sich bevorzugt eine Oberfläche ausbilden, die frei von Kanten und senkrecht zum Substrat verlaufenden Abschnitten ist, so dass sie anschließend von dem nachfolgend aufzubringenden Rückseitenkontakt 4 gut überwachsen werden kann. In der Figur 2d ist beispielhaft ein eher hohes, rundes Profil und als Alternative gestrichelt ein flaches Profil der Isolierlinie 22 gezeigt.

Weiterhin wird in einem Bereich rechts der Trennlinie 20 auf die photoaktive Schichtenfolge 3 eine Abdecklinie 23 aus löslichem Lack ebenfalls strangförmig über die gesamte Breite des Substrats 1 aufgetragen (Figur 2e). Auch hierzu bietet sich wiederum ein Tintenstrahldruckverfahren an. Für die Abdecklinie 23 ist ein möglichst kastenförmiges Profil vorteilhaft, wie in der Figur 2e idealisiert dargestellt. Die Breite der Abdecklinie 23 beträgt typischerweise 50 um und der Abstand der Linie zur rechten Kante der Trennlinie 20 sollte etwa 20 bis 50 µm betragen. Die Höhe der Abdecklinie 23 ist unkritisch, sie sollte jedoch über der Dicke der noch aufzubringenden Rückseitenelektrode 4 liegen. Es ist vorteilhaft, sowohl die Isolierlinie 22 als auch die Abdecklinie 23 mit ein und demselben Prozesskopf von der Schichtseite her aufzubringen. Auch ist denkbar, dass alle strukturierenden Maßnahmen, also das Einstrahlen von Laserlicht zur Bildung der Trennlinien 20 und 21 und das Aufbringen der Isolierlinie 22 und der Abdecklinie 23 von einem einzigen Prozesskopf, der von der Schichtseite her arbeitet, aus erfolgen. Auf diese Weise ist die relative Positionierung aller strukturierenden Elemente zueinander bestmöglich gewährleistet. Falls die Isolierlinie 22 und die Abdecklinie 23 durch einen separaten Prozesskopf nach der Laserstrukturierung aufgebracht werden, kann diesem zweiten Prozesskopf ein optisches Detektionssystem vorgeschaltet sein, durch das die Position des Prozesskopfes an der detektierten Lage der Trennlinien 20 oder 21 nachgeführt wird.

Wie in Figur 2f gezeigt, erfolgt anschließend das Aufbringen der Rückseitenelektrode 4, beispielhaft einer ZnO-Schicht, gefolgt von einer Ag- und/oder Al-Schicht in einem Vakuumdepositionsverfahren oder eventuell in einem Sprühbeschichtungsverfahren. Die unterschiedlichen Profile der Isolierlinie 22 einerseits und der Abdecklinie 23 andererseits führen dazu, dass die Isolierlinie 22 von einer durchgehenden Schicht überwachsen wird, wo hingegen die Flanken der Abdecklinie 23 nicht oder nur unvollständig von der Rückseitenelektrode 4 überwachsen sind.

Anschließend wird der lösliche Lack der Abdecklinie 23 durch ein geeignetes Lösungsmittel entfernt, wodurch in der Rückseitenelektrode 4 die Trennlinie 24 verbleibt. Das Aufbringen der Abdecklinie 23 stellt insofern einen Strukturierungsprozess für eine noch aufzubringende Schicht (hier die Rückseitenelektrode) dar.

Das Verfahren resultiert in dem in der Figur 2g gezeigten Dünnschichtsolarzellen-Modul. In der schematischen Darstellung ist die sich ergebende Segmentierung in ein erstes Segment 5 links, ein zweites Segment 7 rechts und der dazwischen liegenden Kontaktbereich 6 eingetragen. Weiterhin sind Pfeile eingezeichnet, die den Stromfluss symbolisieren und die erfolgte Reihenschaltung der Segmente 5 und 7 verdeutlichen.

Das Dünnschichtsolarzellen-Modul zeichnet sich durch die von der Rückseitenelektrode 4 überwachsene und dadurch vollständig eingeschlossene Isolierlinie 22 aus. Die in der vorangehenden Beschreibung angegebenen typischen Größen und Abstände der Strukturierungselemente können zu einer Breite des Kontaktbereichs von weniger als 200 µm führen, was eine effektive Ausnutzung der Fläche des Dünnschichtsolarzellen-Moduls zur Folge hat.

In Figur 2h ist eine alternative Ausgestaltung des Dünnschichtsolarzellen-Moduls dargestellt. Bei dieser Ausführungsform wurde die Trennlinie 20 nicht über die gesamte im Zusammenhang mit der Figur 2b angegebene Breite ausgeführt. Vielmehr wurde eine schmalere Trennlinie 25, in die die Trennlinie 21 diesmal zentriert eingebracht wird und eine weitere Trennlinie 26 gebildet. Diese Aufteilung in zwei die photoaktive Schichtenfolge 3 unterbrechende Trennlinien kann prozesstechnisch vorteilhaft sein, da eine insgesamt geringere Breite abgetragen werden muss und entsprechend eine kleinere Laserleistung benötigt wird.

Ein Vorteil des in der Figur 2 dargestellten Verfahrens ist, dass zwei Schichten beziehungsweise Schichtenfolgen (vergleiche Figur 2a) aufgebracht werden, bevor ein erster Strukturierungsschritt durchgeführt wird. Die Zahl der Transfers zwischen verschiedenen Prozessstationen und die Zahl der Ein- und Ausschleusevorgänge in das zur Schichtaufbringung notwendige Vakuum wird gering gehalten. Weiterhin können sämtliche Strukturierungsschritte gruppiert hintereinander in einer Prozessstation ausgeführt werden, wodurch eine jeweilige Neuausrichtung des Substrats 1 vor jedem Strukturierungsschritt entfällt. Gegebenenfalls ist es gar möglich, alle Strukturierungsschritte quasi gleichzeitig mit einem Prozesskopf vorzunehmen. Zur Durchsatzerhöhung bei der Strukturierung können zudem mehrere dieser Prozessköpfe zur Bearbeitung der Kontaktbereiche zwischen verschiedenen Segmenten parallel nebeneinander eingesetzt werden. Dabei können diese Prozessköpfe mit separaten Lasern ausgestattet, beziehungsweise von separaten Lasern versorgt werden, oder von einem Laser aus versorgt werden, dessen Licht über Strahlteiler den verschiedenen Prozessköpfen zugeführt wird.

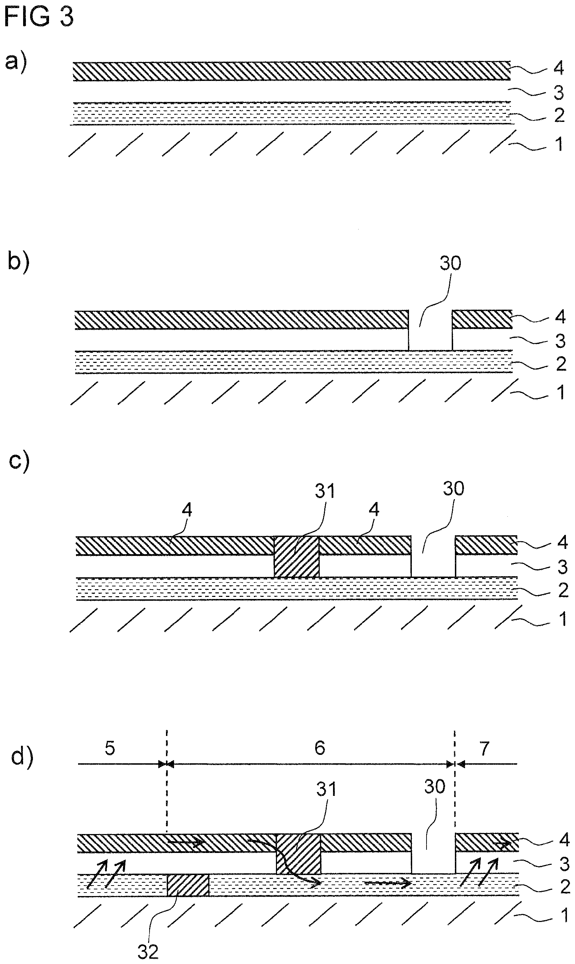

Figur 3 zeigt in analoger Weise wie Figur 2 ein weiteres Beispiel. Die im Zusammenhang mit Figur 2 gemachten Angaben über mögliche Materialien können auf dieses Beispiel übertragen werden.

Wie Figur 3a zeigt, werden hier die Frontseitenelektrode 2, die photoaktive Schichtenfolge 3 und die Rückseitenelektrode 4 auf das Substrat 1 aufgetragen, bevor nachfolgend ein erster Strukturierungsschritt erfolgt. Als erster Strukturierungsschritt wird, wie in Figur 3b dargestellt, eine Trennlinie 30 in die photoaktive Schicht 3 und die Rückseitenelektrode 4 eingebracht. Wie im Zusammenhang mit der Trennlinie 12 bei Figur 1 beschrieben, kann die Trennlinie 30 durch Einstrahlung von Laserlicht geeigneter Wellenlänge, zum Beispiel 532 nm, von der Substratseite her erfolgen.

Anschließend wird die in der Figur 3c gezeigte Kontaktlinie 31 erzeugt. Durch Einstrahlen von Laserlicht geeigneter Wellenlänge aus einem Bereich von beispielsweise 200nm bis 10µ von der Schichtseite her werden die Rückseitenelektrode 4 und die photoaktive Schicht 3 lokal begrenzt aufgeschmolzen, aber nicht verdampft. Ebenfalls ist es möglich, das Laserlicht von der Substratseite her einzustrahlen. In dem Fall sind beispielsweise Wellenlängen von etwa 300nm bis 2 µ geeignet.

Durch Diffusionsprozesse in der Schmelze bildet sich entweder ein Silizid, zum Beispiel AgAlSi mit einer quasi metallischen Leitfähigkeit oder auch ein Eutektikum aus Si und Ag, das ebenfalls eine hohe Leitfähigkeit aufweist. Dadurch kann an dieser Stelle Strom von der Rückseitenelektrode 4 in die Frontseitenelektrode 2 fließen. Bevorzugt besteht dabei im Bereich der Kontaktlinie 31 ein ohmscher Kontakt zur Frontseitenelektrode 2. Das Verfahren zur Bildung der Kontaktlinie 31 ist dabei nicht auf das im Ausführungsbeispiel angenommene Materialsystem beschränkt. Die Mischung von Elementen aus der photoaktiven Schicht 3 und der Rückseitenelektrode 4 in der lokal ausgebildeten Schmelze kann auch bei anderen Systemen zur Ausbildung einer leitfähigen Materialverbindung oder Legierung eingesetzt werden.

Abschließend erfolgt links von der Trennlinie 31 die Ausbildung einer Trennlinie 32 zur Unterbrechung der Frontseitenelektrode 2. Zur Ausbildung der Trennlinie 32 wird Laserstrahlung einer Wellenlänge, die in der Frontseitenelektrode absorbiert wird, zum Beispiel 1064 nm, durch das Substrat 1 eingebracht. Die Leistung der Laserstrahlung und die Bearbeitungszeit wird so gewählt, dass die Frontseitenelektrode 2 lokal erwärmt und zu Rekristallisationsprozessen angeregt wird, ohne dass Material physikalisch entfernt wird. Im Gegensatz zu den im Zusammenhang mit Figur 2 beschriebenen Trennlinien 20 und 21 oder der Trennlinie 30 im vorliegenden Ausführungsbeispiel wird bei der Trennlinie 32 Material also nicht entfernt, sondern nur in seinen Eigenschaften, insbesondere seiner Leitfähigkeit, verändert. Es wird keine Lücke gebildet. Die über der Frontseitenelektrode 2 liegenden Schichten, die photoaktive Schicht 3 und die Rückseitenelektrode 4, werden nicht oder nur unwesentlich beeinflusst. Es ist dabei vorteilhaft, gepulste Laserstrahlung einzusetzen, durch die lokal ein kurzzeitiges Aufheizen der Frontseitenelektrode 2 erreicht werden kann, bevor die eingebrachte Wärmemenge in die Umgebung dissipiert. So kann lokal kurzzeitig ein hohes Temperaturniveau erreicht werden, ohne dass die Umgebung signifikant erwärmt wird. Besonders geeignet sind dabei Pulsdauern, die kürzer als Mikrosekunden sind und bevorzugt im Bereich von Nano- oder Picosekunden liegen. Die dadurch hervorgerufene Veränderung der Mikrostruktur des TCO-Materials der Frontseitenelektrode 2 im Bereich der Trennlinie 32 führt zu einer deutlichen Herabsetzung ihrer Leitfähigkeit in diesem Bereich. Grund ist, dass für die Leitfähigkeit von TCO-Schichten im wesentlichen Dotierstoffe verantwortlich sind, die als Folge des Rekristallisationsprozesses nicht mehr im Kristall eingebaut sind. Ein möglicher zweiter Mechanismus, der zu einer Herabsetzung der Leitfähigkeit führt, ist ein durch Mischen des Materials der Frontseitenelektrode 2 mit dem Material der darüber liegenden photoaktiven Schichtenfolge 3. Dabei bilden der Sauerstoff des TCO-Materials der Frontseitenelektrode 2 mit dem Silizium der photoaktiven Schichtenfolge 3 elektrisch isolierendes Siliziumoxid (SiO oder SiO2). Dieser Vorgang wird durch die hohe Oxidbildungsenthalpie von Silizium entscheidend beeinflusst. Hierbei kann es vorteilhaft sein, die Parameter für die Laserstrahlung (Wellenlänge, Leistung, Pulsdauer) so zu wählen, dass die über der Frontseitenelektrode 2 liegende photoaktive Schichtenfolge 3 ebenfalls mit aufgeheizt wird. Dabei ist es auch denkbar, Laserstrahlung auf zwei Wellenlängen gleichzeitig einzustrahlen, von denen die eine bevorzugt in der Frontseitenelektrode 2 absorbiert wird und die andere bevorzugt in der photoaktiven Schichtenfolge 3 absorbiert wird. Es wird jedoch wiederum kein Material entfernt. Die Rückseitenelektrode 4 sollte nicht verändert werden, so dass die Stromleitung vom ersten Segment 5 über den Kontaktbereich 6 in das zweite Segment 7 rechts nicht beeinträchtigt wird.

In beiden Fällen (Ausbau von Dotierstoffen; Siliziumoxidbildung) wird Frontseitenelektrode 2 elektrisch unterbrochen oder ihre Leitfähigkeit zumindest ausreichend abgesenkt. Auch dieses Verfahren zur Bildung der Trennlinie 32 ist nicht auf das im Ausführungsbeispiel angenommene Materialsystem beschränkt. Beispielsweise können bei CI(G)S-basierten photoaktiven Schichtenfolgen 3 Cu-Oxide oder bei photoaktiven Schichtenfolgen 3, die Cd enthalten, Cd-Oxide in der Trennlinie 32 gebildet werden, die die Frontseitenelektrode 2 elektrisch unterbrechen bzw. deren Leitfähigkeit im Bereich der Trennlinie 32 ausreichend absenken.

Das Resultat ist in der Figur 3d dargestellt, in die wiederum die gebildeten Bereiche eines ersten Segments 5, eines zweiten Segments 7 sowie des dazwischen liegenden Kontaktbereichs 6 dargestellt sind und in der der Stromfluss bei der Serienverschaltung der Segmente 5, 7 durch Pfeile symbolisiert ist. Das entstandene Dünnschichtsolarzellen-Modul zeichnet sich durch die siliziumhaltige Kontaktierungslinie 31 in der Rückseitenelektrode 4 aus und durch die rekristallisierte oder Siliziumoxid enthaltende Trennlinie 32 in der Frontseitenelektrode 1.

Wie schon beim ersten Ausführungsbeispiel ist auch hier vorteilhaft, dass alle Strukturierungsschritte gruppiert werden können. Außerdem können zumindest zwei der Strukturierungsmaßnahmen, nämlich das von der Schichtseite her erfolgende Erstellen der Trennlinie 30 und der Kontaktierungslinie 31 von einem einzigen Prozesskopf aus ausgeführt werden. Die verbleibende Strukturierungsmaßnahme, das Erstellen der Trennlinie 32, kann in der gleichen Position des Dünnschichtsolarzellen-Moduls durch einen parallel zum ersten Prozesskopf geführten zweiten Prozesskopf von der Substratseite her ausgeführt werden. Besonders vorteilhaft ist, dass alle Schichten aufgebracht werden, bevor die Gruppe der Strukturierungsmaßnahmen durchgeführt wird. Zur Durchsatzerhöhung bei der Strukturierung können zudem ebenfalls mehrere Prozessköpfe parallel eingesetzt werden.

In einer alternativen Ausgestaltung des Verfahrens ist es denkbar, mit einem Substrat 1 zu starten, das bereits mit einer TCO-Schicht als Frontseitenelektrode 2 versehen ist und bei dem die Trennlinie 32 auf herkömmliche Art bereits erzeugt wurde. In diesem Fall werden die photoaktive Schichtenfolge 3 und die Rückseitenelektrode 4 folglich auf eine vorstrukturierte Frontseitenelektrode 2 aufgebracht. Auch wenn somit nicht mehr alle Strukturierungsmaßnahmen zusammengefasst werden, bietet dieses Verfahren einen Vorteil gegenüber dem Stand der Technik, bei dem jede Schichtabscheidung von einer anschließenden Strukturierungsmaßnahme gefolgt wird.

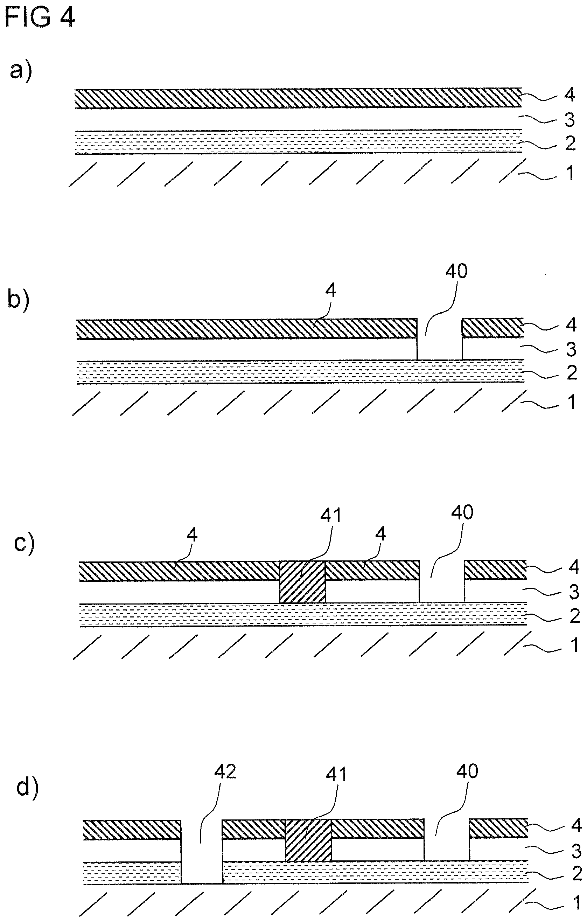

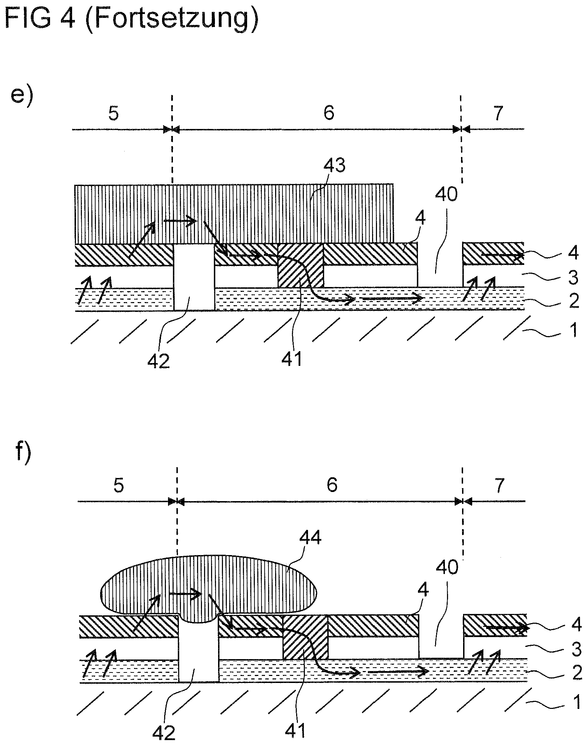

Figur 4 zeigt zwei Ausführungsbeispiele eines erfindungsgemäßen Verfahrens zur Herstellung von Dünnschichtsolarzellen-Modulen.

Wie bei dem in Figur 3 gezeigten Beispiel werden zunächst ein Frontseitenkontakt 2, eine photoaktive Schichtenfolge 3 und ein Rückseitenkontakt 4 auf ein Substrat 1 aufgebracht. (Figur 4a). Anschließend wird eine Trennlinie 40 in die Rückseitenelektrode 4 und die photoaktive Schichtenfolge 3 eingebracht (Figur 4b). Lateral von der Trennlinie 40 beabstandet wird dann eine Kontaktierungslinie 41 zwischen der Rückseitenelektrode 4 und der photoaktiven Schichtenfolge 3 gebildet. Bis zu diesem Prozessstadium verläuft das Verfahren genau wie das im Zusammenhang mit Figur 3 dargestellte Verfahren, weswegen bezüglich weiterer Details auf die dortige Beschreibung verwiesen wird.

Anschließend wird wie in Figur 4d dargestellt eine Trennlinie 42 erzeugt, die den gesamten Schichtaufbau mit Ausnahme des Substrats, also Frontseitenelektrode 2, photoaktive Schichtenfolge 3 und Rückseitenelektrode 4, unterbricht. Die Trennlinie 42 kann bevorzugt durch Einstrahlung von Laserlicht einer geeigneten Wellenlänge (1064 nm oder 355 nm) durch das Substrat erfolgen. Alternativ kann auch von der Schichtseite her mit sehr hoher Strahlenergie gearbeitet werden. Es ist dabei sowohl denkbar, das alle Schichten gleichzeitig entfernt werden, als auch, dass in nacheinander erfolgenden Schritten Laserlicht der gleichen oder verschiedener Wellenlängen eingestrahlt wird, wodurch die Schichten in mehreren Schritten abgetragen werden. Beispielsweise könnten in einem ersten Schritt - wie bei der Bildung der Trennlinie 40 - die photoaktive Schichtenfolge 3 und die Rückseitenelektrode 4 entfernt werden und in einem zweiten Schritt - wie bei der Bildung der Trennlinie 10 (siehe Figur 1) oder der Trennlinie 20 (siehe Figur 2) - die Frontseitenelektrode 2 entfernt werden.

Schließlich wird ein elektrisch leitfähiges Klebeband 43 über die Trennlinie 42 aufgebracht, wodurch die unerwünschte Unterbrechung der Rückseitenelektrode 4 durch die Trennlinie 42 elektrisch wieder geschlossen wird. Das elektrisch leitfähige Klebeband 43 kann dabei zum Beispiel aus einem leitfähigen Polymer bestehen. Beim Aufbringen ist dafür Sorge zu tragen, dass das Klebeband 43 nicht über die Trennlinie 40 verlegt wird, deren Zweck ja gerade die elektrische Trennung der Rückseitenelektroden 4 benachbarter Segmente 5, 7 ist. Der Abstand der Trennlinien 40 und 42 liegt bei etwa 100 um. Ein Verlegen des Klebebands 43 mit einer solchen Positionsgenauigkeit ist technisch jedoch machbar. Dabei ist es nicht notwendig, dass das leitfähige Klebeband 43 durchgehend über die gesamte Breite des Dünnschichtsolarzellen-Moduls aufgebracht wird. Es ist ausreichend, wenn über die Breite verteilte Abschnitte des leitfähigen Klebebands 43 als Strombrücken vorhanden sind.

Das aus diesem Herstellungsverfahren resultierende Dünnschichtsolarzellen-Modul ist in der Figur 4e abgebildet. Wiederum sind die benachbarten Segmente 5 und 7 sowie der dazwischen liegende Kontaktbereich 6 eingetragen und der Stromfluss der Serienverschaltung der Segmente ist durch eingezeichnete Pfeile symbolisiert.

Eine alternative Methode zur Verbindung der durch die Trennlinie 42 getrennten Rückseitenelektrode 4 ist in Figur 4f gezeigt. Statt des Klebebands 43 wird ein leitfähiger Strang 44 aus einer leitfähigen Paste aufgetragen, die in ihrer Konsistenz so gewählt wird, dass sie nicht oder nur unwesentlich in die Trennlinie 42 eindringt. Das Aufragen der leitfähigen Paste, bei der es sich um ein aushärtendes leitfähiges Polymer handeln kann, kann in Tintenstrahldrucktechnik erfolgen. Wie im Fall des leitfähigen Klebebands ist nicht erforderlich, dass der leitfähige Strang 44 über die Breite des Moduls durchgängig ist, wenngleich sich bei einer durchgängiger Ausführung eine bessere elektrische Verbindung und eine schützenden Versieglung der Trennlinie 42 als Vorteile ergeben.

Die aus diesen beiden Verfahrensalternativen resultierenden Dünnschichtsolarzellen-Module zeichnen sich durch die Silizid-haltige Kontaktlinie 41 sowie das auf die Rückseitenelektrode 4 aufgebrachte Klebeband 43 beziehungsweise den leitfähigen Strang 44 aus.

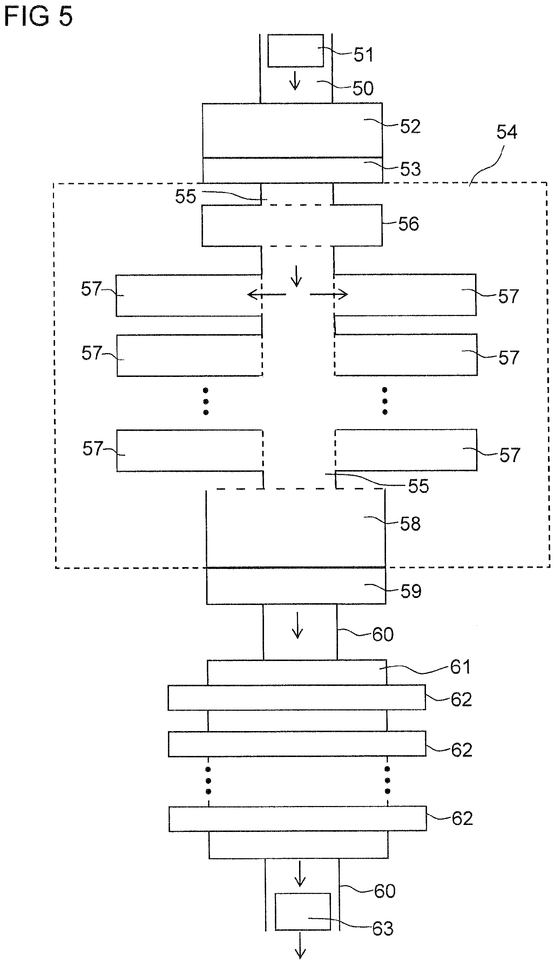

Figur 5 zeigt eine Produktionslinie als geeignete Vorrichtung zur Durchführung des anmeldegemäßen Herstellungsverfahren für Dünnschichtsolarzellen-Module.

Die Produktionslinie weist ein erstes Transportsystem 50 zur Aufnahme eines Glassubstrats 51 auf. Das Transportsystem 50 mündet in eine Reinigungsstation 52, die über eine erste Vakuumschleuse 53 mit einer Beschichtungseinrichtung 54 verbunden ist. Der Beschichtungseinrichtung 54 weist ein zweites Transportsystem 55, eine erste PVD/(LP)CVD-Beschichtungsstation 56, mehrere PECVD-Beschichtungsstationen 57 und eine zweite PVD/(LP)CVD-Beschichtungsstation 58 auf. An die zweite PVD/(LP)CVD-Beschichtungsstation 58 schließt sich eine zweite Vakuumschleuse 59 an, aus der ein drittes Transportsystem 60 herausführt. Dieses dritte Transportsystem 60 führt durch einen Strukturierungseinrichtung 61, die mehrere verfahrbare Prozessköpfe 62 aufweist. Nach Durchlaufen der Strukturierungseinrichtung 61 auf dem dritten Transportsystem 60 verlässt ein fertiges Dünnschichtsolarzellen-Rohmodul 63 die Produktionslinie.

Ausgangspunkt der Herstellung eines Dünnschichtsolarzellen-Moduls in der dargestellten Produktionslinie ist das über das erstes Transportsystem 50 zugeführte Glassubstrat 51. Vorzugsweise ist die Produktionslinie so ausgelegt, dass Flachglasscheiben der üblichen Breite von 3,21 m aufgenommen und verarbeitet werden können. Die Produktionslinie kann in dem Fall auch bevorzugt direkt an eine Flachglasproduktionslinie angekoppelt werden. Nach einer Reinigung in der Reinigungsstation 52 wird das Glassubstrat 51 direkt und ohne Kontakt zur umgebenden Atmosphäre der ersten Vakuumschleuse 53 zugeführt. Auf eine Reinraumumgebung zum Schutz vor Staubpartikeln kann daher verzichtet werden.

In der anschließenden ersten PVD/(LP)CVD-Beschichtungsstation 56 kann die Elektrode aufgebracht werden. Im Falle einer CVD (chemical vapor deposition)-Beschichtung kann ein Niederdruckverfahren (LPCVD - low pressure CVD) eingesetzt werden. Weiterhin kann in die erste PVD/(LP)CVD-Beschichtungsstation 56 eine (Trocken-) Ätzvorrichtung integriert sein. Bevorzugt arbeitet die erste PVD/(LP)CVD-Beschichtungsstation 56 in einem Durchlaufverfahren (in-line).

Darauf folgend kann in den unterschiedlichen PECVD-Beschichtungsstationen 57 eine photoaktive Schichtenfolge aufgebracht werden. Bevorzugt sind diese PECVD-Beschichtungsstationen 57 als stationäre Beschichtungsstationen ausgeführt. Alternativ kann auch in einer dieser Stationen die Elektrode in einem stationären Prozess aufgebracht werden. In dem Fall könnte auf die erste PVD/(LP)CVD-Beschichtungsstation 56 verzichtet werden. Weiterhin besteht auch die Möglichkeit, dass das Glassubstrat 51 bereits eine Frontelektrode aufweist, beispielsweise durch on-line Beschichtung in der Produktionslinie des Glasherstellers. Auch in dem Fall könnte auf die erste PVD/(LP)CVD-Beschichtungsstation 56 verzichtet werden. Es ist weiterhin denkbar, dass im Falle der Herstellung der Frontseitenelektroden in einem PVD-Beschichtungsprozess ein nachgestellter (Trocken-) Ätzprozess für die notwendige Aufrauung der Frontelektrode eingesetzt wird. Die entsprechende Prozessstation ist entweder in die PVD/(LP)CVD-Beschichtungsstation 56 integriert oder ist eine der PECVD-Beschichtungsstationen 57. Bedingt durch die Anordnung der Beschichtungsstationen 56, 57 und 58 kann als zweites Transportsystem 55 im Vakuum der Beschichtungseinrichtung 54 ein unaufwändiger linearer Rollenantrieb dienen.

Zur Herstellung von Si-Tandemzellen können beispielsweise von den PECVD-Beschichtungsstationen 57 wasserstoff terminierte amorphe p-, i- und n-dotierte a-Si:H-Schichten und/oder mikrokristalline p-, i- und n-dotierte Si-Schichten und/oder weitere Absorberschichten auf der Basis von a-Si(Ge):H nacheinander aufgebracht werden. Die Produktionslinie ist darüber hinaus so ausgelegt, dass das Glassubstrat 51 nach den PECVD-Beschichtungsstationen 57 ohne Vakuumunterbrechung die PVD/(LP)CVD-Beschichtungsstation 58 durchläuft, wobei die Metallschicht einer Rückseitenelektrode zum Beispiel in einem Sputterprozess aufgetragen wird. Die PVD/(LP)CVD-Beschichtungsstation 58 ist bevorzugt wiederum als in-line Station für ein Durchlaufbeschichtungsverfahren ausgelegt und kann im Fall einer CVD-Beschichtung im Niederdruckverfahren arbeiten. Es ist auch denkbar, dass mehrere PVD/(LP)CVD-Beschichtungsstationen 58 vorgesehen sind, um verschiedene Metalle abscheiden zu können, zum Beispiel Ag und/oder Al und/oder Mo.

Anschließend wird das Glassubstrat 51 durch die zweite Vakuumschleuse 59 wieder aus dem Vakuum geschleust und durchläuft auf dem dritten Transportsystem 60 die Strukturierungseinrichtung 61 der Produktionslinie.

Sinngemäß kann die angegebene Produktionslinie auch zur Herstellung von Dünnschichtsolarzellen-Modulen auf Basis von Verbindungshalbleitern eingesetzt werden (CdTe, CIS).

Die im Zusammenhang mit den Figuren 2 bis 4 beschriebenen Verfahren zeichnen sich dadurch aus, dass eine Gruppierung in Prozessschritte zur Schichtabscheidung und Prozessschritte zur Strukturierung, d.h. zur Bildung von Trenn-, Isolier-, Abdeck- und Kontaktlinien, möglich ist. Dieses spiegelt sich in der Zusammenfassung der zum Abscheiden der Schichten benötigten Prozessstationen in der Beschichtungseinrichtung 54 und der Zusammenfassung der zur Strukturierung benötigten Strukturierungswerkzeuge in der Strukturierungseinrichtung 61 wider. Als Strukturierungswerkzeuge können Laser, Laserübertragungsoptiken, Tintenstrahldruckköpfe und Vorrichtungen zum Auftragen von Klebebändern eingesetzt werden. Dabei ist vorteilhaft, möglichst viele der Strukturierungswerkzeuge, die für miteinander in Beziehung stehende Prozessschritte benötigt werden, auf einem Prozesskopf 62 zu integrieren. Dieses betrifft beispielsweise Laser verschiedener Wellenlänge, die unterschiedliche, aber möglichst korrekt zueinander zu positionierende Trennlinien erzeugen. In diesem Zusammenhang wird auch auf die Ausführungen zu den Figuren 2 bis 4 betreffend vorteilhafter Ausgestaltungen der Prozessköpfe hingewiesen. Zur Durchsatzerhöhung können mehrere gleiche Prozessköpfe 62 vorhanden sein, mit denen parallel verschiedene Bereiche eines Glassubstrat 51 bearbeitet werden können.

Falls nach dem Verlassen der Strukturierungseinrichtung 61 noch das Aufbringen der Rückseitenelektrode 4 notwendig ist, zum Beispiel zur Herstellung des im Zusammenhang mit Figur 2 beschriebenen Dünnschichtsolarzellen-Moduls, kann gegebenenfalls die PVD/(LP)CVD-Beschichtungsstation 58 statt in der Beschichtungseinrichtung 54 integriert zu sein separat ausgeführt sein. Davon unbeeinflusst ist die Zusammenfassung der PECVD-Beschichtungsstationen 57 und der PVD/(LP)CVD-Beschichtungsstation 56 in der Beschichtungseinrichtung 54.

Anschließend liegt das fertige Dünnschichtsolarzellen-Rohmodul 63 vor. Nachfolgend sind lediglich periphere Verarbeitungsschritte wie Verkapseln, Entschichten der Ränder, Kontaktieren usw. zur endgültigen Fertigstellung des Dünnschichtsolarzellen-Moduls notwendig. Diese können unabhängig außerhalb der Produktionslinie durchgeführt werden oder ebenfalls noch in die Produktionslinie integriert werden.

In einer Ausführungsform des Verfahrens zur Herstellung des Dünnschichtsolarzellen-Moduls mit der Vielzahl von elektrisch in Reihe geschalteten und auf dem gemeinsamen Substrat 1 angeordneten Segmenten 5, 7, wird die Abdecklinie 23 bei der Strukturierung nachfolgend aufzubringender Schichten durch ein Tintenstrahldruckverfahren aufgebracht.

Das Dünnschichtsolarzellen-Modul mit der Vielzahl von elektrisch in Reihe geschalteten Segmenten 5, 7, ist in einer Ausführungsform durch ein Verfahren wie in Verbindung mit den Figuren 2, 3 beziehungsweise 5 erläutert hergestellt.

Bei dem Dünnschichtsolarzellen-Modul ist in einer Ausführungsform die Isolierlinie 22 aus isolierendem Material in den Bereich der Trennlinie 20, 21, die die erste Elektrode 2 des Dünnschichtsolarzellen-Moduls zur Bildung der Segmente 5, 7 unterbricht, aufgebracht und wird von der zweiten Elektrode 4 abgedeckt.

Die Isolierlinie 22 enthält in einer Ausführungsform ein isolierendes Polymer.

Bei dem Dünnschichtsolarzellen-Modul ist in einer Ausführungsform die Elektrode 2 aus einem elektrisch leitfähigen Oxid durch eine Trennlinie 32 elektrisch unterbrochen, wobei die Elektrode 2 im Bereich der Trennlinie 32 lokal andere physikalische Eigenschaften aufweist als außerhalb der Trennlinie 32.

Bei dem Dünnschichtsolarzellen-Modul beruhen die lokal anderen physikalischen Eigenschaften im Bereich der Trennlinie 32 in einer Ausführungsform auf einer Änderung der Dotierung nach einer Rekristallisation der Elektrode 4 im Bereich der Trennlinie 32.

Bei dem Dünnschichtsolarzellen-Modul beruhen die lokal anderen physikalischen Eigenschaften im Bereich der Trennlinie 32 in einer Ausführungsform auf einer Bildung eines Oxids eines Elements aus der zur Elektrode 2 benachbarten photoaktiven Schichtfolge 3 im Bereich der Trennlinie 32.

Bei dem Dünnschichtsolarzellen-Modul weist die photoaktive Schichtenfolge 3 in einer Ausführungsform Si auf und die Trennlinie 32 enthält Si-Oxid.

Das Dünnschichtsolarzellen-Modul mit der Vielzahl von elektrisch in Reihe geschalteten Segmenten 5, 7 umfasst in einer Ausführungsform die erste Elektrode 2, die photoaktive Schichtfolge 3 und die zweite Elektrode 4. Bei dem Dünnschichtsolarzellen-Modul ist die Kontaktlinie 31 vorhanden, über die die zweite Elektrode 4 mit der ersten Elektrode 2 zur Serienschaltung der Segmente 5, 7 elektrisch verbunden ist, wobei die Kontaktlinie 31 im Bereich der photoaktiven Schichtfolge 3 eine leitfähige Materialverbindung und/oder eine leitfähige Legierung aus Elementen der photoaktiven Schichtfolge 3 und der zweiten Elektrode 4 enthält.

Bei dem Dünnschichtsolarzellen-Modul weist die photoaktive Schichtenfolge 3 in einer Ausführungsform Si auf und die Kontaktlinie 31 enthält ein Silizid.

Bei dem Dünnschichtsolarzellen-Modul mit der Vielzahl von elektrisch in Reihe geschalteten Segmenten 5, 7 ist in einer Ausführungsform das elektrisch leitfähiges Klebeband 43 oder der Strang 44 der leitfähigen Paste im Bereich der Trennlinie 42, die die erste Elektrode 2 des Dünnschichtsolarzellen-Moduls zur Bildung der Segmente 5, 7 und die zweite Elektrode 4 unterbricht, zur Wiederherstellung der elektrischen Verbindung auf die zweite Elektrode 4 aufgebracht.

Die Produktionslinie zur Herstellung des Dünnschichtsolarzellen-Moduls auf dem Glassubstrat 51 nach einem der in Verbindung mit den Figuren 2, 3 beziehungsweise 4 beschriebenen Verfahren umfasst in einer Ausführungsform die Beschichtungseinrichtung 54, die die erste Vakuumschleuse 53, die mindestens zwei Beschichtungsstationen 56, 57, 58 und die zweite Vakuumschleuse 59 aufweist und derart eingerichtet ist, dass das Glassubstrat 51 nach Einschleusen in die Beschichtungseinrichtung 54 durch die erste Vakuumschleuse 53 die mindestens zwei Beschichtungsstationen 56, 57, 58 oder 503, 56 nacheinander unter Vakuumbedingungen durchlaufen kann, bevor das Substrat durch die zweite Vakuumschleuse 59 wieder aus der Beschichtungseinrichtung 54 geschleust wird.

Bei der Produktionslinie sind in einer Ausführungsform in der Beschichtungseinrichtung 54 die PECVD-Beschichtungsstationen 57 und/oder die PVD/(LP)CVD-Beschichtungsstationen 56, 58 vorgesehen.

Bei der Produktionslinie ist in einer Ausführungsform die Reinigungsstation 52 unmittelbar mit der ersten Vakuumschleuse 53 gekoppelt.

Bei der Produktionslinie ist in einer Ausführungsform der erste lineare Rollenantrieb als Transportsystem 55 durch die Beschichtungseinrichtung 54 vorgesehen.

Bei der Produktionslinie ist in einer Ausführungsform die Strukturierungseinrichtung 61 vorgesehen, bei der an dem verfahrbaren Prozesskopf 62 mindestens zwei verschiedene Strukturierungswerkzeuge zur Strukturierung mindestens einer Schicht des Dünnschichtsolarzellen-Moduls bereitgestellt werden.

Bei der Produktionslinie ist in einer Ausführungsform der Prozesskopf 62 dazu eingerichtet, gleichzeitig Laserstrahlung in mindestens zwei verschiedenen Wellenlängen bereitzustellen.

Bei der Produktionslinie ist der Prozesskopf 62 in einer Ausführungsform dazu eingerichtet Laserstrahlung bereitzustellen und weist die Tintenstrahldruckvorrichtung auf.

Bei der Produktionslinie ist der Prozesskopf 62 in einer Ausführungsform dazu eingerichtet, das Klebeband 43 auf dem Dünnschichtsolarzellen-Modul zu verlegen.

### Bezugszeichenliste

- 1: Substrat
- 2: erste Elektrode (Frontseitenelektrode)
- 3: photoaktive Schichtenfolge
- 4: zweite Elektrode (Rückseitenelektrode)
- 5: erstes Segment
- 6: Kontaktierungsbereich
- 7: zweites Segment

- 10, 11, 12: Trennlinien

- 20, 21: Trennlinien
- 22: Isolierlinie
- 23: Abdecklinie
- 24 - 26: Trennlinien

- 30: Trennlinie
- 31: Kontaktierungslinie
- 32: Trennlinie

- 40: Trennlinie
- 41: Kontaktierungslinie
- 42: Trennlinie
- 43: leitfähiges Klebeband
- 44: leitfähiger Strang

- 50: erstes Transportsystem
- 51: Glassubstrat
- 52: Reinigungsstation
- 53: erste Vakuumschleuse
- 54: Beschichtungseinrichtung
- 55: zweites Transportsystem
- 56: erste PVD/(LP)CVD-Beschichtungsstation
- 57: PECVD-Beschichtungsstation
- 58: zweite PVD/(LP)CVD-Beschichtungsstation
- 59: zweite Vakuumschleuse
- 60: drittes Transportsystem
- 61: Strukturierungseinrichtung
- 62: Prozesskopf
- 63: Dünnschichtsolarzellen-Rohmodul

## Patentansprüche

1. Verfahren zur Herstellung eines Dünnschichtsolarzellen-Moduls mit einer Vielzahl von elektrisch in Reihe geschalteten und auf einem gemeinsamen Substrat (1) angeordneten Segmenten (5, 7), mit
- Schritten zum Aufbringen von Schichten auf das Substrat (1) zur Bildung mindestens einer Elektrode (2), einer photoaktiven Schichtfolge (3) und einer weiteren Elektrode (4) und
- Schritten zum Strukturieren aufgebrachter Schichten zur Bildung der Vielzahl von Segmenten (5, 7),
bei dem die Elektrode (2), die photoaktive Schichtfolge (3) und die weitere Elektrode (4) aufgebracht werden, bevor nachfolgend Schritte zum Strukturieren ausgeführt werden, wobei die Schritte zum Strukturieren umfassen:
- Erzeugen einer Trennlinie (42), die die Elektrode (2), die photoaktive Schichtfolge (3) und die weitere Elektrode (4) unterbricht,
- Einbringen einer weiteren Trennlinie (40) in die weitere Elektrode (4) und die photoaktive Schichtfolge (3),
- Bilden einer Kontaktierungslinie (41) lateral von der weiteren Trennlinie (40) beabstandet und zwischen der Trennlinie (42) und der weiteren Trennlinie (40), wobei die Elektrode (2) mit der weiteren Elektrode (4) zur Reihenschaltung der Segmente (5, 7) mittels der Kontaktierungslinie (41) elektrisch verbunden ist,
- Aufbringen eines elektrisch leitfähigen Klebebands (43) oder eines leitfähigen Strangs (44) aus einer leitfähigen Paste über die Trennlinie (42), wodurch die Unterbrechung der weiteren Elektrode (4) durch die Trennlinie (42) elektrisch wieder geschlossen wird.

2. Verfahren nach Anspruch 1, bei dem die Herstellung einer Elektrode (2, 4) das Aufbringen von mindestens einer Schicht aus einem transparenten leitfähigen Oxid und/oder einer Metallschicht umfasst.

3. Verfahren nach einem der Ansprüche 1 oder 2, bei dem die Herstellung der photoaktiven Schichtfolge (3) das Aufbringen von mindestens einer Einzelschicht aus amorphem oder mikrokristallinem Si und/oder amorphem oder mikrokristallinem SiGe und/oder einem Verbindungshalbleiter, insbesondere CdTe oder CIS oder CIGS umfasst.

4. Verfahren nach Anspruch 3, bei dem die Herstellung der photoaktiven Schichtfolge (3) das Aufbringen einer p-dotierten, einer intrinsischen und einer n-dotierten Schicht amorphen Si und/oder einer p-dotierten, einer intrinsischen und einer n-dotierten Schicht mikrokristallinen Si und/oder einer p-dotierten, einer intrinsischen und einer n-dotierten Schicht amorphen Si(Ge) umfasst.

5. Verfahren nach einem der Ansprüche 1 bis 4, bei dem das Aufbringen der Schichten durch einen PVD-Prozess, insbesondere einen Sputter-Prozess, und/oder einen CVD-Prozess, insbesondere einen PECVD-Prozess, erfolgt.

6. Verfahren nach einem der Ansprüche 1 bis 5, bei dem die Trennlinie (42) durch Einstrahlen von Laserstrahlung und/oder durch mechanisches Ritzen und/oder durch selektives Ätzen erstellt wird.

7. Verfahren nach Anspruch 6, bei dem Laserlicht derart eingestrahlt wird, dass eine oder mehrere Schichten lokal entfernt werden.

8. Verfahren nach Anspruch 6, bei dem Laserlicht derart eingestrahlt wird, dass eine oder mehrere Schichten lokal derart aufgeheizt werden, dass sich die physikalischen Eigenschaften mindestens einer der Schichten, insbesondere ihre Leitfähigkeit, verändert.

9. Verfahren nach einem der Ansprüche 1 bis 8, bei dem die Kontaktlinie (41) durch Einstrahlen von Laserstrahlung erstellt wird.

10. Verfahren nach Anspruch 9, bei dem Laserlicht derart eingestrahlt wird, dass übereinander liegende Schichten aus unterschiedlichen Materialien lokal aufgeheizt werden und sich eine Materialverbindung ausbildet, die von den ursprünglichen Materialien abweichende physikalische Eigenschaften hat und insbesondere leitfähig ist.

11. Verfahren nach Anspruch 10, bei dem lokal eine Schmelze der unterschiedlichen Materialien gebildet wird und bei dem aus der Schmelze die Materialverbindung entsteht.

12. Verfahren nach einem der Ansprüche 6 oder 8, bei dem eine Isolierlinie aus einem elektrisch isolierenden Material innerhalb der Trennlinien (42) erstellt wird.

13. Verfahren nach Anspruch 12, bei dem die Isolierlinie durch ein Tintenstrahldruckverfahren aufgebracht wird.

14. Verfahren nach einem der Ansprüche 1 bis 13, umfassend:
- Ausbilden einer Kontaktlinie (41) zwischen der weiteren Elektrode (4) und der Elektrode (2), die einen ohmschen Kontakt zwischen der weiteren Elektrode (4) und der Elektrode (2) bildet, wobei die Kontaktlinie (41) ausgebildet wird, bevor das elektrisch leitfähige Klebebands (43) oder der leitfähige Strang (44) aus der leitfähigen Paste aufgebracht wird.

## Claims

1. A method of fabricating a thin-film solar cell module with a plurality of segments (5, 7) that are electrically connected in series and arranged on a common substrate (1), the method comprising:
- steps for applying layers to the substrate (1) to form at least one electrode (2), a photoactive layer sequence (3) and a further electrode (4) and
- steps for structuring applied layers to form the plurality of segments (5, 7),
in which the electrode (2), the photoactive layer sequence (3) and the further electrode (4) are applied before subsequent structuring steps are carried out, wherein the structuring steps comprise:
- creating a separating line (42), which interrupts the electrode (2), the photoactive layer sequence (3) and the further electrode (4),
- introducing a further separating line (40) into the further electrode (4) and the photoactive layer sequence (3),
- forming a contact line (41) laterally spaced apart from the further separating line (40) and between the separating line (42) and the further separating line (40), wherein the electrode (2) is electrically connected to the further electrode (4) by means of the contact line (41) for the series connection of the segments (5, 7),
- applying an electrically conductive adhesive strip (43) or a conductive strand (44) of a conductive paste over the separating line (42), as a result of which the interruption of the further electrode (4) by the separating line (42) is electrically reclosed.

2. The method according to claim 1, wherein the fabrication of an electrode (2, 4) comprises applying at least one layer of a transparent conductive oxide and/or a metal layer.

3. The method according to one of claims 1 or 2, wherein the fabrication of the photoactive layer sequence (3) comprises applying at least one individual layer of amorphous or microcrystalline Si and/or amorphous or microcrystalline SiGe and/or a compound semiconductor, in particular CdTe or CIS or CIGS.

4. The method according to claim 3, wherein the fabrication of the photoactive layer sequence (3) comprises applying a p-doped, an intrinsic and an n-doped layer of amorphous Si and/or a p-doped, an intrinsic and an n-doped layer of microcrystalline Si and/or a p-doped, an intrinsic and an n-doped layer of amorphous Si(Ge).

5. The method according to one of claims 1 to 4, wherein the application of the layers takes place by a PVD process, in particular a sputtering process, and/or a CVD process, in particular a PECVD process.

6. The method according to one of claims 1 to 5, wherein the separating line (42) is created by irradiation with laser radiation and/or by mechanical scoring and/or by selective etching.

7. The method according to claim 6, wherein laser light is directed such that one or more layers are locally removed.

8. The method according to claim 6, wherein laser light is directed such that one or more layers are locally heated such that the physical properties of at least one of the layers are changed, in particular the conductivity thereof.

9. The method according to one of claims 1 to 8, wherein the contact line (41) is created by irradiation with laser radiation.

10. The method according to claim 9, wherein laser light is directed such that overlying layers of different materials are locally heated and a material compound is formed which has physical properties that differ from the original materials and which, in particular, is conductive.

11. The method according to claim 10, wherein a melt of the different materials is formed locally and wherein the material compound results from the melt.

12. The method according to one of claims 6 or 8, wherein an isolating line composed of an electrically isolating material is created within the separating lines (42).

13. The method according to claim 12, wherein the isolating line is applied by an ink jet printing method.

14. The method according to one of claims 1 to 13, comprising:
- forming a contact line (41) between the further electrode (4) and the electrode (2), which forms an ohmic contact between the further electrode (4) and the electrode (2), wherein the contact line (41) is formed before the electrically conductive adhesive strip (43) or the conductive strand (44) of the conductive paste is applied.

## Revendications

1. Procédé servant à fabriquer un module de cellules solaires à couches minces avec une pluralité de segments (5, 7) branchés en série électriquement et disposés sur un substrat (1) commun, comprenant
- des étapes pour appliquer des couches sur le substrat (1) pour former au moins une électrode (2), une succession photoactive de couches (3) et une autre électrode (4), et
- des étapes pour structurer des couches appliquées pour former la pluralité de segments (5, 7),
dans lequel l'électrode (2), la succession photoactive de couches (3) et l'autre électrode (4) sont appliquées avant que des étapes de structuration ne soient exécutées par la suite, dans lequel les étapes de structuration comprennent :
- la génération d'une ligne de séparation (42), qui interrompt l'électrode (2), la succession photoactive de couches (3) et l'autre électrode (4),
- l'introduction d'une autre ligne de séparation (40) dans l'autre électrode (4) et la succession photoactive de couches (3),
- la formation d'une ligne de mise en contact (41) à distance latéralement de l'autre ligne de séparation (40) et entre la ligne de séparation (42) et l'autre ligne de séparation (40), dans lequel l'électrode (2) est reliée électriquement à l'autre électrode (4) pour brancher en série les segments (5, 7) au moyen de la ligne de mise en contact (41),
- l'application d'une bande adhésive (43) électriquement conductrice ou d'un brin (44) à partir d'une pâte conductrice sur la ligne de séparation (42), ce qui a pour effet que l'interruption de l'autre électrode (4) par la ligne de séparation (42) est à nouveau fermée électriquement.

2. Procédé selon la revendication 1, dans lequel la fabrication d'une électrode (2, 4) comprend l'application d'au moins une couche à partir d'un oxyde conducteur transparent et/ou d'une couche métallique.

3. Procédé selon l'une quelconque des revendications 1 ou 2, dans lequel la fabrication de la succession photoactive de couches (3) comprend l'application d'au moins une couche individuelle à partir de Si amorphe ou microcristallin et/ou de SiGe amorphe ou microcristallin et/ou d'un semiconducteur composé, en particulier de CdTe ou de CIS ou de CIGS.

4. Procédé selon la revendication 3, dans lequel la fabrication de la succession photoactive de couches (3) comprend l'application d'une couche à dopage p, d'une couche intrinsèque et d'une couche à dopage n composée de Si amorphe et/ou d'une couche à dopage p, d'une couche intrinsèque et d'une couche à dopage n composée de Si microcristallin et/ou d'une couche à dopage p, d'une couche intrinsèque et d'une couche à dopage n composée de Si(Ge) amorphe.

5. Procédé selon l'une quelconque des revendications 1 à 4, dans lequel l'application des couches est effectuée par un processus PVD , en particulier un processus de pulvérisation, et/ou un processus CVD, en particulier un processus PECVD.

6. Procédé selon l'une quelconque des revendications 1 à 5, dans lequel la ligne de séparation (42) est créée par irradiation d'un rayonnement laser et/ou par gravure mécanique et/ou par décapage sélectif.

7. Procédé selon la revendication 6, dans lequel de la lumière laser est émise de telle manière qu'une ou plusieurs couches sont localement enlevées.

8. Procédé selon la revendication 6, dans lequel de la lumière laser est émise de telle manière qu'une ou plusieurs couches sont localement réchauffées de telle manière que les propriétés physiques d'au moins une des couches, en particulier leur conductivité, se modifient.

9. Procédé selon l'une quelconque des revendications 1 à 8, dans lequel la ligne de contact (41) est créée par irradiation d'un rayonnement laser.

10. Procédé selon la revendication 9, dans lequel de la lumière laser est émise de telle manière que des couches superposées à partir de matériaux différents sont réchauffées localement et qu'un composé de matériau se forme, qui a des propriétés physiques divergeant des matériaux d'origine et est en particulier conductive.

11. Procédé selon la revendication 10, dans lequel localement une matière fondue des matériaux différents est formée et dans lequel la liaison des matières résulte de la matière fondue.

12. Procédé selon l'une quelconque des revendications 6 ou 8, dans lequel une ligne d'isolation est créée à partir d'un matériau électriquement isolant à l'intérieur des lignes de séparation (42).

13. Procédé selon la revendication 12, dans lequel la ligne d'isolation est appliquée par un procédé d'impression à jet d'encre.

14. Procédé selon l'une quelconque des revendications 1 à 13, comprenant :
- la réalisation d'une ligne de contact (41) entre l'autre électrode (4) et l'électrode (2), qui forme un contact ohmique entre l'autre électrode (4) et l'électrode (2), dans lequel la ligne de contact (41) est réalisée avant que la bande adhésive (43) électriquement conductrice ou le brin (44) conducteur composé de la pâte conductrice ne soit appliquée ou appliqué.
